# EUROPEAN PATENT APPLICATION

(11) **EP 2 372 778 A2**
(43) Date of publication of application: **05.10.2011**
(21) Application number: 11250393.3
(22) Date of filing: 28.03.2011
(51) Int. Cl.: H01L 31/0224

(54) **Solar cell**

(30) Priority: 29.03.2010 JP 2010074919
(71) Applicant: Napra co.,Ltd, Tokyo 124-0022 (JP)
(72) Inventor: Sekine, Shigenobu, Tokyo 124-0013 (JP); Sekine, Yurina, Tokyo 124-0013 (JP); Kuwana, Yoshiharu, Tokyo 124-0022 (JP)
(74) Representative: Marshall, Caroline

(57) **Abstract**

A solar cell includes a first conductivity-type semiconductor layer, a second conductivity-type semiconductor layer, a first electrode, and a second electrode. The first conductivity-type semiconductor layer has a front side intended to serve as a light-receiving surface. The second conductivity-type semiconductor layer is disposed on a back side of the first conductivity-type semiconductor layer, forming a p-n junction together with the first conductivity-type semiconductor layer. The first electrode passes through the second conductivity-type semiconductor layer toward the first conductivity-type semiconductor layer with a tip extending into and ending within the first conductivity-type semiconductor layer. The second electrode is disposed at a back side of the solar cell.

## Description

### BACKGROUND OF THE INVENTION

### 1. Field of the Invention

The present invention relates to a solar cell.

### 2. Description of the Related Art

Recently, expectations for solar cells as a next-generation energy source have been rapidly raised, particularly, in view of global environmental issues. The variety of solar cells is quite wide, including a silicon-type, a compound-type, an organic-type, a dye-sensitized solar cell, and so on.

Among them, the most well-known is a silicon solar cell, in which, for example, an n+ layer is formed at a light-receiving surface of a p-type silicon substrate being a semiconductor substrate, whereby the p-type silicon substrate and the n+ layer forms a p-n junction, as disclosed in Japanese Unexamined Patent Application Publication Nos. 2009-123761 and 2008-270743.

An antireflection film and silver electrodes are respectively formed on a first major surface being the light-receiving surface of the p-type silicon substrate. These silver electrodes are composed of a bus bar electrode for connection to an interconnector and a finger electrode extending from the bus bar electrode. A p+ layer is formed on a second major surface opposite from the light-receiving surface of the p-type silicon substrate. On the back side of the p-type silicon substrate, there are formed an aluminum electrode and silver electrodes for connection to the interconnector, respectively.

In the above structure, however, there is a problem that incident light can be blocked by the silver electrodes, the bus bar electrodes, and the finger electrodes on the first major surface, causing a loss due to the shadow, while carrier recombination loss occurs beneath the silver electrodes.

As a means for solving the problem, Japanese Unexamined Patent Application Publication Nos. 2009-123761 and 2008-270743 propose a structure in which the silver electrode on the first major surface is partially applied to the silver electrode on the second major surface using a through electrode previously formed in the silicon substrate.

Even in the case of employing the above through electrode structure, however, incident light can be blocked by the silver electrodes, causing a loss due to the shadow. As a natural consequence, this reduces power generation efficiency.

Moreover, since a plurality of silver electrodes should be arranged at intervals on the first major surface in the form of stripe, there is a limit in increasing the area of a single solar cell.

### SUMMARY OF THE INVENTION

It is an object of the present invention to provide a solar cell having high light-receiving efficiency and power generation efficiency per unit area.

It is another object of the present invention to provide a solar cell suitable for increasing the area.

In order to achieve the above object, a solar cell according to the present invention comprises a first conductivity-type semiconductor layer, a second conductivity-type semiconductor layer, a first electrode, and a second electrode. The first conductivity-type semiconductor layer has a front side intended to serve as a light-receiving surface, while the second conductivity-type semiconductor layer is disposed on a back side of the first conductivity-type semiconductor layer, forming a p-n junction together with the first conductivity-type semiconductor layer.

The first electrode passes through the second conductivity-type semiconductor layer toward the first conductivity-type semiconductor layer with a tip extending into and ending within the first conductivity-type semiconductor layer, while the second electrode is disposed at a back side of the solar cell.

As described above, since the second conductivity-type semiconductor layer is disposed on a back side of the first conductivity-type semiconductor layer, forming a p-n junction together with the first conductivity-type semiconductor layer, incident sunlight energy can be transformed into a photoelectromotive force.

Since the first electrode passes through the second conductivity-type semiconductor layer toward the first conductivity-type semiconductor layer with a tip extending into and ending within the first conductivity-type semiconductor layer, the first electrode does not appear on the light-receiving surface. Accordingly, the first electrode does not block the incident light to cause a loss due to the shadow. This makes it possible to realize a solar cell having high light-receiving efficiency and power generation efficiency per unit area.

Moreover, since the first electrode has a current collecting effect on the first conductivity-type semiconductor layer, the conventionally indispensable light-receiving surface electrode becomes unnecessary, eliminating the limit in increasing the area. A large-area solar cell can be realized by arranging the first electrodes at proper intervals, for example, in a matrix form.

Furthermore, since the first electrode passes through the second conductivity-type semiconductor layer toward the first conductivity-type semiconductor layer, its connection to the outside can be located at the back side of the solar cell. The second electrode is located at the back side of the solar cell from the first. Therefore, all electrodes such as bus bar electrodes and finger electrodes can be processed at the back side, preventing the incident light from being blocked by them to cause a loss due to the shadow. This makes it possible to realize a solar cell having high light-receiving efficiency and power generation efficiency per unit area.

According to the present invention, as described above, there can be obtained the following effects:
(a) To provide a solar cell having high light-receiving efficiency and power generation efficiency per unit area; and
(b) To provide a solar cell suitable for increasing the area.

The present invention will be more fully understood from the detailed description given hereinbelow and the accompanying drawings which are given by way of illustration only, and thus not to be considered as limiting the present invention.

### BRIEF DESCRIPTION OF THE DRAWINGS

Fig. 1 is a plan view of a part of a solar cell according to the present invention as seen from a light-receiving surface side; and
Fig. 2 is a sectional view taken along line II-II in Fig. 1.

### DESCRIPTION OF THE PREFERRED EMBODIMENTS

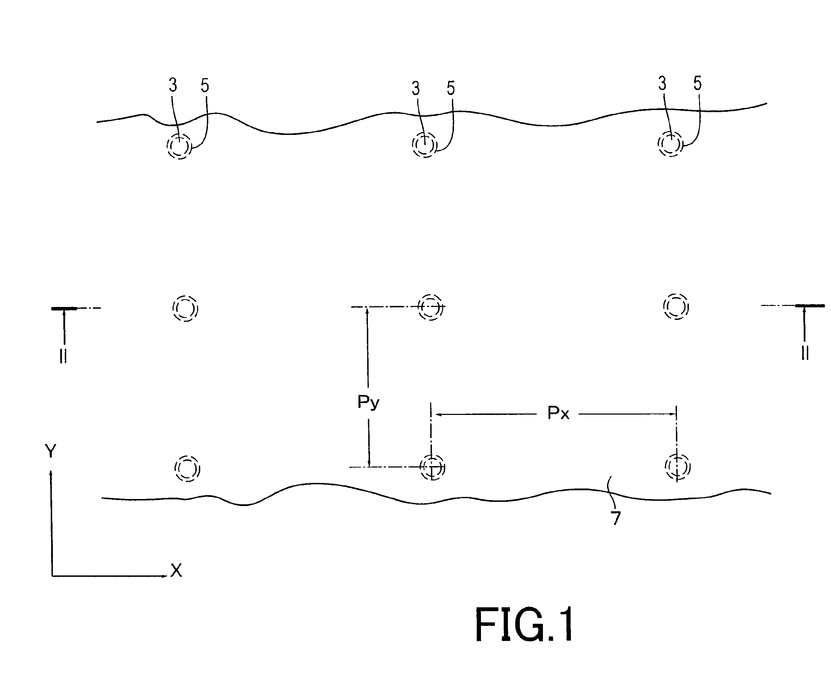

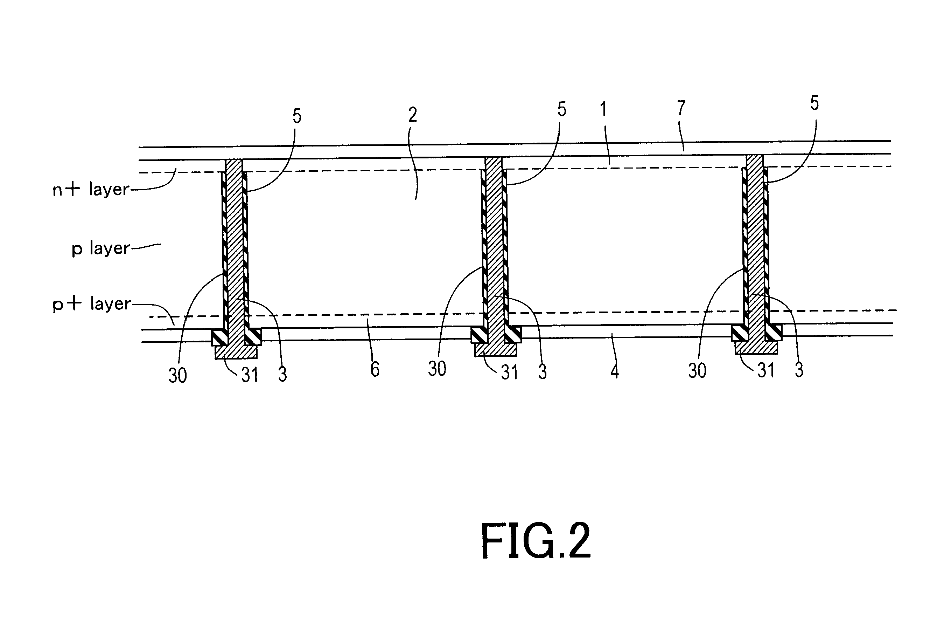

Figs. 1 and 2 illustrate a typical example of a crystalline silicon solar cell comprising a first conductivity-type semiconductor layer 1, a second conductivity-type semiconductor layer 2, a first electrode 3, and a second electrode 4.

The first conductivity-type semiconductor layer 1 has a front side intended to serve as a light-receiving surface, while the second conductivity-type semiconductor layer 2 is disposed on the back side of the first conductivity-type semiconductor layer 1, forming a p-n junction together with the first conductivity-type semiconductor layer 1. More specifically, the second conductivity-type semiconductor layer 2 is a p-type silicon substrate, and the first conductivity-type semiconductor layer 1 being an n+ layer is formed at a light-receiving surface of the second conductivity-type semiconductor layer 2. Thus, the second conductivity-type semiconductor layer 2 being the p-type silicon substrate and the first conductivity-type semiconductor layer 1 being the n+ layer form the p-n junction. The second conductivity-type semiconductor layer 2 is most preferably a silicon crystal, but may also be a polycrystalline silicon or amorphous silicon.

The method for forming the first conductivity-type semiconductor layer 1 being the n+ layer on the second conductivity-type semiconductor layer 2 being the p-type silicon substrate is well known as disclosed in Japanese Unexamined Patent Application Publication No. 2009-123761 and so on, and therefore, no specific description is required.

An antireflection film 7 (or a protective film) is formed on a first major surface intended to serve as the light-receiving surface of the first conductivity-type semiconductor layer 1. On the other hand, a p+ layer 6 is formed on a second major surface opposite from the light-receiving surface of the second conductivity-type semiconductor layer 2. On the back side of the second conductivity-type semiconductor layer 2, there is formed the second electrode 4.

The above structure can also be found in conventional solar cells. The present invention is characterized by the first electrode 3. The first electrode 3 passes through the second conductivity-type semiconductor layer 2 toward the first conductivity-type semiconductor layer 1 with a tip extending into and ending within the first conductivity-type semiconductor layer 1. The first electrode 3 is covered with an insulating film 5 at a portion that requires electrical insulation, for example, at a portion passing through the second conductivity-type semiconductor layer 2 and at a rear-end portion close to the second electrode 4. The tip extending into the first conductivity-type semiconductor layer 1 is not covered with the insulating film 5. In the figure, the tip surface of the first electrode 3 is located at the same level as the surface of the first conductivity-type semiconductor layer 1 but may be slightly lowered. A rear end 31 of the first electrode 3 can be used as a terminal.

In the illustrated embodiment, the first electrode 3 is formed by filling a conductive material into a minute hole 30 passing through the second conductivity-type semiconductor layer 2 and reaching the first conductivity-type semiconductor layer 1. Preferably, the minute holes 30 are distributed at a given area density. On an XY-plane of the substrate 1, preferably, the minute holes 30 are arranged at a given pitch distance Px, Py in a matrix form. The number of rows and the number of columns are arbitrary. The minute hole 30 may have a hole diameter on the order of *µ* m. The pitch distance may be of such an order, too.

The minute hole 30 can easily be formed by using a well-known drilling technique such as laser drilling process or chemical drilling process. The first electrode 3 can be formed by filling a conductive paste or a molten metal into the minute hole 30 thus drilled. This process enables formation of dense first electrodes 3 without leaving any void in the minute holes 30. A more desirable result can be obtained by hardening them while keeping the pressure.

The above pressure-filling type fabrication process belongs to a stamping and makes the cost of equipment considerably less expensive and requires less processing time, as compared with a conventional dry-etching process using an ICP-RIE. Thus, it is possible to achieve a low-cost solar cell.

The first electrode 3 may be formed by using a conductive paste, as described above, but is preferably formed by using a molten metal from the viewpoint of improving electrical characteristics and quality of the electrode itself. In this case, major examples of metal materials to be used include bismuth (Bi), indium (In), tin (Sn), and copper (Cu). Particularly, if bismuth (Bi) is contained, dense first electrodes 3 can be formed without leaving any void or cavity in the minute holes 30 because of volume expansion characteristics of the bismuth (Bi) at the time of solidification. The molten metal may be prepared by melting powder of particles (nanoparticles) which are made of the above metal materials as aggregate of polycrystalline substances with a particle size of 1 *µ* m or less and a crystal size of 200 nm or less.

In the solar cell according to the present invention, as described above, since the p-n junction is formed between the second conductivity-type semiconductor layer 2 and the first conductivity-type semiconductor layer 1, sunlight energy incident on the light-receiving surface can be transformed into a photoelectromotive force.

Here, since the first electrode 3 passes through the second conductivity-type semiconductor layer 2 toward the first conductivity-type semiconductor layer 1 with a tip extending into and ending within the first conductivity-type semiconductor layer 1, the first electrode 3 does not appear on the light-receiving surface. Accordingly, the first electrode 3 does not block the incident light to cause a loss due to the shadow. This makes it possible to realize a solar cell having high light-receiving efficiency and power generation efficiency per unit area.

Moreover, since the first electrode 3 has a current collecting effect on the first conductivity-type semiconductor layer 1, the conventionally indispensable light-receiving surface electrode becomes unnecessary, eliminating the limit in increasing the area. A large-area solar cell can be realized by arranging the first electrodes 3 at proper intervals, for example, in a matrix form.

Furthermore, since the first electrode 3 passes through the second conductivity-type semiconductor layer 2 toward the first conductivity-type semiconductor layer 1, its connection to the outside can be located at the back side of the solar cell. The second electrode 4 is located at the back side of the solar cell from the first. Therefore, all electrodes such as bus bar electrodes and finger electrodes can be processed at the back side, preventing the incident light from being blocked by them to cause a loss due to the shadow. This makes it possible to realize a solar cell having high light-receiving efficiency and power generation efficiency per unit area.

The present invention is not limited to the crystalline silicon solar cell illustrated in the embodiment but is applicable to various types of solar cells, including a solar cell using a compound-semiconductor (e.g., CIGS), a solar cell using an organic semiconductor, and a multijunction solar cell having a plurality of p-n junctions, for example.

Examples of silicon solar cells include a monocrystalline silicon type, a polycrystalline silicon type, a microcrystalline silicon type, an amorphous silicon type, and a thin-film silicon type, and also known are a hybrid type (HIT type) and so on.

Examples of compound solar cells include an InGaAs solar cell, a GaAs-based solar cell, and a CIS-based (chalcopyrite-based) solar cell. The CIS-based (chalcopyrite-based) solar cell is the one using as a material of a light absorbing layer a I-III-VI group compound, called chalcopyrite, including Cu, In, Ga, Al, Se, S and so on, typified by Cu(In, Ga)Se₂, Cu(In, Ga)(Se, S)₂, and CuInS₂, which are abbreviated as CIGS, CIGSS, and CIS, respectively.

The present invention is applicable to any case, and in its application, the tip of the first electrode 3 must be kept within the first conductivity-type semiconductor layer 1 so as to prevent the tip from projecting from the surface of the first conductivity-type semiconductor layer 1 that is closest to the light incidence surface.

While the present invention has been particularly shown and described with respect to preferred embodiments thereof, it will be understood by those skilled in the art that various changes in form and detail may be made therein without departing from the spirit, scope and teaching of the invention.

## Claims

1. A solar cell comprising a first conductivity-type semiconductor layer (1), a second conductivity-type semiconductor layer (2), a first electrode (3), and a second electrode (4),
the first conductivity-type semiconductor layer (1) having a front side intended to serve as a light-receiving surface,
the second conductivity-type semiconductor layer (2) being disposed on a back side of the first conductivity-type semiconductor layer (1), forming a p-n junction together with the first conductivity-type semiconductor layer (1),
the first electrode (3) passing through the second conductivity-type semiconductor layer (2) toward the first conductivity-type semiconductor layer (1) with a tip extending into and ending within the first conductivity-type semiconductor layer (1),
the second electrode (4) being disposed at a back side of the solar cell.
